# EUROPEAN PATENT SPECIFICATION

(11) **EP 2 962 120 B1**
(45) Date of publication and mention of the grant of the patent: **06.02.2019**
(21) Application number: 14706856.3
(22) Date of filing: 27.02.2014
(51) Int. Cl.: G01R 31/06, H05B 6/06

(54) **AN INDUCTION COOKTOP AND THE CONTROL METHOD THEREOF**
INDUKTIONSKOCHFELD UND STEUERUNGSVERFAHREN DAFÜR
TABLE DE CUISSON À INDUCTION ET PROCÉDÉ DE COMMANDE ASSOCIÉ

(30) Priority: 27.02.2013 TR 201302398
(43) Date of publication of application: 06.01.2016
(73) Proprietor: Arçelik Anonim Sirketi, 34950 Istanbul (TR)
(72) Inventor: DOGANAY, Serdar Gokhan, 34950 Istanbul (TR); AYTEKIN, Burcak, 34950 Istanbul (TR)
(86) International application number: PCT/EP2014/053841
(87) International publication number: WO 2014/131834

(56) References cited:
- DE-A1- 19 738 967
- JP-A- 2000 082 577
- JP-A- 2001 215 253
- JP-A- 2004 103 414
- JP-A- 2008 251 222

## Description

### AN INDUCTION COOKTOP AND THE CONTROL METHOD THEREOF

The present invention relates to an induction cooktop and a related control method wherein the coils are prevented from being installed erroneously.

White goods producers have designed a large number of different types of cooktops that can generate heat with electricity. Among these, the cooktops that provide the heating of the ferromagnetic based cooking vessels by induction method are widely preferred by customers since they provide savings in electrical energy.

In an induction cooktop having cooking zones for heating an average diameter cooking vessel, the cooking zone is generally formed by a single coil and generally problems arise when the small diameter cooking vessels are placed on the cooking zone and heated since the coil forming the cooking zone of the induction cooktop is designed so as to complete the electrical circuit together with the ferromagnetic based cooking vessel. Similarly, when a large diameter cooking vessel is placed on cooking zone for heating which is intended for heating an average diameter cooking vessel, the large diameter cooking vessel cannot be heated sufficiently.

White goods producers have designed induction cooktops that comprise more than one cooking zone where each one is suitable to heat a different diameter cooking vessel in order to enable consumers to use different diameter cooking vessels. In induction cooktops designed in this manner, each cooking zone is formed by an induction coil that is suitable for the diameter and the electrical power of the cooking vessel to be heated.

Since coils with different diameters are used during the production of an induction cooktop having more than one cooking zone, these coils with different diameters may be installed erroneously to the electrical connection parts, for example the connectors, in the circuit board. For example, a coil with a diameter of 145 mm can be installed erroneously to the cooking zone where a coil with a diameter of 180 mm should be installed. In this situation, the electrical power intended for the cooking zone formed by the respective coil cannot be provided and the cooking vessel with the diameter intended for the cooking zone formed by the respective coil cannot be heated sufficiently. In the reverse situations, permanent damages may occur in the induction cooktop due to erroneous installation. Situations such as this result in consumer complaints and the rate of malfunctioning reported to the related service departments increase.

In order to solve this problem, in the state of the art Japanese Patent Application No. JP 2004 103414 A, an induction cooktop is explained wherein the induction heating coils forming the cooking zones are electrically connected with electric cables of different lengths to the terminals in the induction cooktop. Document JP 2008 251222 A describes an induction cooktop in which, during a self-diagnosis at start-up, electric power is supplied to a heating coil. The resulting current is measured in order to check if there is an abnormality in the circuit configuration. Document EP 1 889 515 B discloses an induction heating device comprising a coil and having an electrical component with a value representative of the induction heating device type, so that an induction heating power source can identify the type of induction heating device coupled to the induction heating power source.

The aim of the present invention is the realization of an induction cooktop which enables the determination of whether or not the coils are installed correctly by the electronic software and hardware contained therein, without necessitating manual control, while the induction cooktop is energized and without requiring to take structural precautions that will increase production costs during the production of the induction cooktop.

The control unit of the induction cooktop, realized in order to attain the aim of the present invention and explicated in the attached claims, has a normal operation mode wherein the cooking vessel is heated and a service mode executed during the production of the induction cooktop wherein it is determined whether or not a coil is correctly installed to the electrical connection part whereto it is intended to be installed and in the service mode the control unit retrieves the characteristic information defining the characteristic of the coil to be installed and the configuration data defining the electrical connection part whereto the coil is intended to be installed from an interior and/or exterior recording medium, drives the coil to be analyzed with a drive signal by operating the generator for a predetermined time period, detects the electric current passing through the coil being analyzed and determines whether or not the analyzed coil is correctly installed to the intended electrical connection part depending on the detected current, the received characteristic information and the received configuration data. Thus, while the induction cooktop is in the service mode during the production of the induction cooktop, it can be determined whether or not the coils are installed correctly without requiring manual control.

The characteristic information used by the induction cooktop of the present invention can determine the attenuation duration of each coil to be installed, the phase difference or the resonance difference between the coil current and the voltage generated by the drive signal applied to the coil. Thus, three different methods can be implemented for preventing erroneous installation. It is possible to determine whether or not a coil is installed correctly using these methods implemented by the induction cooktop in the service mode during the production of the induction cooktop.

Furthermore, in the control method executed by the control unit of the induction cooktop in the service mode, the step of retrieving the characteristic information, the step of operating the generator, the step of detecting the current and the step of determining whether or not there is erroneous installation are realized respectively for each coil to be installed. Thus, all the coils to be installed to the induction cooktop are enabled to be installed without any errors. The induction cooktop of the present invention can show on its display the result of the analysis that indicates whether or not the analyzed coil is installed correctly to the intended electrical connection part. Thus, the warning about an analyzed coil being installed erroneously can be made via the display of the cooktop during installation. The induction cooktop of the present invention comprises an internal recording medium wherein the characteristic information of one or more than one coil to be installed and the configuration data defining the electrical connection parts intended for the said one or more than one coil can be recorded. Thus, while the induction cooktop is in the service mode during the production of the induction cooktop, it can be determined without requiring manual control whether or not the coils are installed correctly according to the data specified in the internal recording medium. The characteristic information and the configuration data can be retrieved by the control unit from an external recording medium with wired or wireless communication.

The coil realized in order to attain the aim of the present invention and explicated in the attached claims, is suitable to be installed to the electrical connection part of the induction cooktop of the present invention, and comprises a permanent recording medium whereon the characteristic information of the coil and the configuration data defining the electrical connection part intended for installation can be recorded and which can be read by the control unit of the induction cooktop by wired or wireless communication. Thus, while the induction cooktop is in the service mode during the production of the induction cooktop, it can determined whether or not the coils are installed correctly without requiring manual control by using the data recorded on for example the RFID transponders (Radio Frequency Identification Transponder) disposed on the coils. Recording the data on the coils to be installed provides convenience.

The model embodiments related to the induction cooktop and the control method realized in order to attain the aim of the present invention are illustrated in the attached figures, where:
Figure 1 - is the schematic view of an induction cooktop in an embodiment of the present invention.
Figure 2 - is the schematic view of the generator, the rectifier and the induction coil circuits in an embodiment of the present invention.
Figure 3 - is the view of attenuation of the coil current in an embodiment of the present invention.
Figure 4 - is the view of the phase difference between the current and the voltage of the coil in an embodiment of the present invention.

The elements illustrated in the figures are numbered as follows:
1. Induction cooktop
2. Cooking zone
3. Coil
4. Electrical connection part
5. Generator
6. Control unit
7. Drive signal
8. Coil current
9. Attenuation duration
10. Phase difference
11. Control panel
12. IGBT Transistor
13. Diode
14. Capacitor
15. IGBT drive
16. PWM signal line
17. Rectifier
18. Mains inlet
19. Current control components

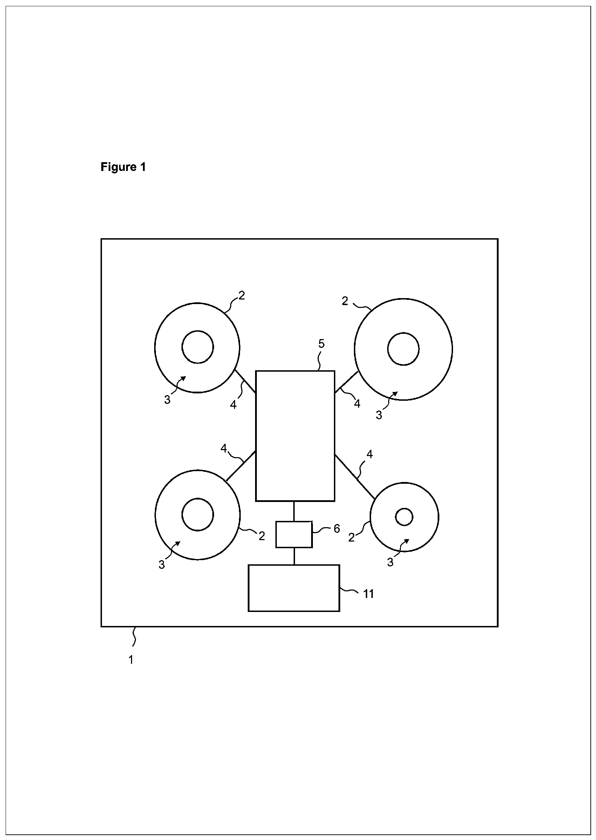

The induction cooktop (1) comprises at least one cooking zone (2) suitable for heating a cooking vessel placed thereon, an electrical connection part (4) that enables the coil (3) that forms each cooking zone (2) to be installed detachably, a generator (5) that provides the driving of the coil (3) through the respective electrical connection part (4) and a control unit (6) that enables the generator (5) to be controlled (Figure 1).

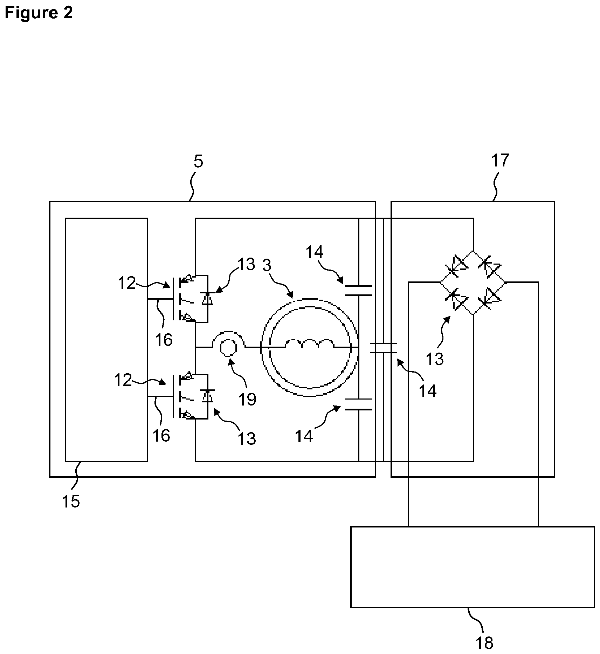

The generator (5) providing the driving of the coils (3) comprises two IGBT transistors (12), two diodes (13) and two capacitors (14) (Figure 2). Furthermore, the generator (5) comprises an IGBT drive (15) that provides the driving of the IGBT transistors (12) (Figure 2). The IGBT drive (15) generates a PWM (Power Width Modulation) signal and drives the IGBT transistors (12) through a PWM signal line (16) (Figure 2). The alternative current at the mains inlet (18) is delivered to the generator (5) by being converted into direct current through a rectifier (17) (Figure 2).

The control unit (6) of the induction cooktop (1),
- has a normal operating mode wherein the cooking vessel is heated and a service mode executed during the production of the induction cooktop wherein it is determined whether or not a coil (3) is correctly installed to the electrical connection part (4) whereto it is intended to be installed,
and in the service mode executed during the production of the induction cooktop
- retrieves the characteristic information defining the characteristic of the coil (3) to be installed and the configuration data of the electrical connection part (4) intended for the coil (3) to be installed from an internal and/or external recording medium,
- drives the coil (3) to be analyzed with a drive signal (7) by operating the generator (5) for a predetermined time period,
- detects the electric current (8) passing through the coil (3) being analyzed and
- determines whether or not the analyzed coil (3) is correctly installed to the intended electrical connection part depending on the detected coil current (8), the retrieved characteristic information and the retrieved configuration data (Figure 1 to Figure 4).

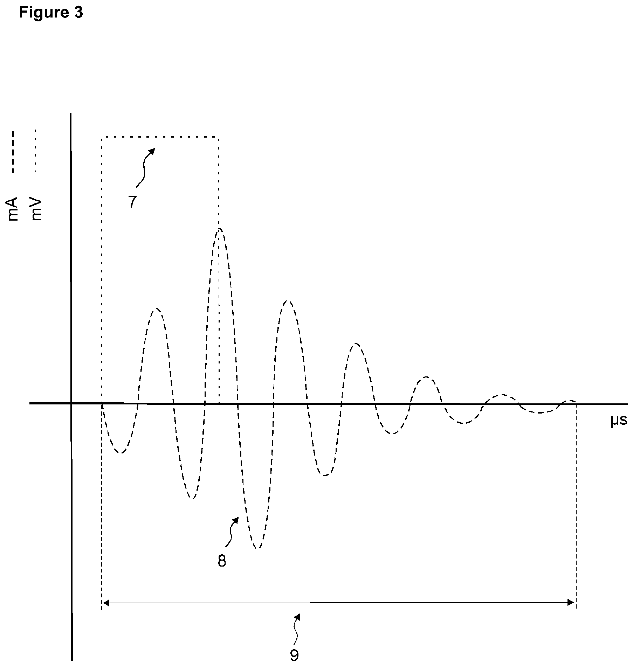

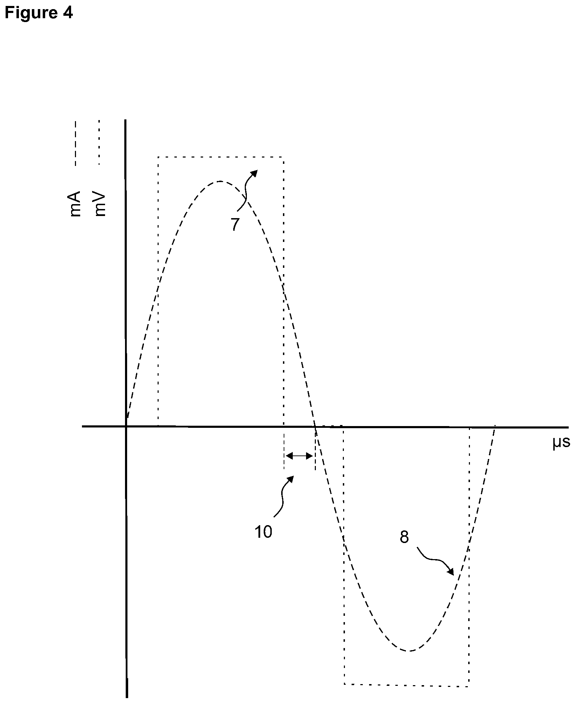

Each coil (3) installed to the induction cooktop (1) has a predetermined resistance R (Ω Ohm) and inductance L (Henry). These resistance and inductance values are specific to the coils. The coil circuits have a predetermined capacity C (Farad) (Figure 2). Similarly, the LC values are specific to the coils. In an embodiment of the present invention, the characteristic information determines the attenuation duration (9) of each coil (3) (Figure 3). The attenuation durations (9) of the coils (3) are measured previously and used as characteristic information in the service mode. In an embodiment of the present invention, the characteristic information defines the phase difference (10) between the current (8) of each coil (3) and the voltage generated by the drive signal (7) applied on the coil (3) (Figure 4). The phase differences (10) to be detected when the coils (3) are driven under a predetermined ferromagnetic load are premeasured and used as characteristic information in the service mode. In an embodiment of the present invention, the characteristic information defines the resonance frequency of each coil (3) to be installed. Thus, three different methods are enabled to be implemented for preventing any erroneous installation.

In an embodiment of the present invention, in the service mode executed during the production of the induction cooktop the control unit (6)
- retrieves the characteristic information of the coil (3) to be installed defining the attenuation duration (9) and the configuration data of the electrical connection part (4) intended for the coil (3) to be installed from an internal and/or external recording medium,
- provides the driving of the coil (3) to be analyzed with a drive signal (7) by instantaneously operating the generator (5),
- detects the attenuation duration (9) of the electric current (8) passing through the analyzed coil (3),
- determines whether or not the analyzed coil (3) is correctly installed to the intended electrical connection part (4) depending on the detected attenuation duration (9), the retrieved characteristic information and the retrieved configuration data of the coil (3) to be installed (Figure 1 to Figure 3).

Thus, it can be quickly determined whether or not a coil (3) is correctly installed. When the generator (5) is operated instantaneously, the coil (3) to be analyzed is driven with a drive signal (7) for example for 50 microseconds (Figure 3).

In an embodiment of the present invention, in the service mode executed during the production of the induction cooktop, the control unit (6)
- retrieves the characteristic information defining the phase difference (10) between the current (8) and the drive signal (7) of the coil (3) to be installed and the configuration data defining the electrical connection part (4) intended for the coil (3) to be installed from an internal and/or external recording medium,
- drives the coil (3) to be analyzed with a drive signal (7) by operating the generator (5) for a predetermined time period,
- detects the phase difference (10) between the electric current (8) passing through the coil (3) being analyzed and the drive signal (7) driving the coil (3) being analyzed and
- determines whether or not the analyzed coil (3) is correctly installed to the intended electrical connection part (4) depending on the detected phase difference (10), the retrieved characteristic information and the retrieved configuration data of the coil (3) to be installed (Figure 1, Figure 2, and Figure 4).

Thus, it can be quickly determined whether or not a coil (3) is correctly installed.

In an embodiment of the present invention, the characteristic information and the configuration data relating to the coils (3) to be installed are recorded in a LUT (Look-up Table) which is not shown in the figures. In an embodiment of the present invention, while determining, the control unit (6) compares the detected values like the attenuation duration (9) or the phase difference (10) relating to the coil (3) with the values read from the LUT.

In an embodiment of the present invention, the induction cooktop (1) furthermore comprises a control panel (11)
- that has a display that displays the analysis result showing whether or not the analyzed coil (3) is installed correctly to the intended electrical connection part (4),
- that is connected to the control unit (6) bi-directionally and
- that has a user input area that enables the user to enter input for activating the cooking zones (2) or ending the activation (Figure 1).

In the service mode executed during the production of the induction cooktop, the control unit (6) furthermore
- enables the analysis result, determining whether or not the analyzed coil (3) is installed correctly to the intended electrical connection part (4), to be shown on the display depending on the result of the determination (Figure 1 to Figure 4).

Thus, the warning that an analyzed coil (3) is installed incorrectly is visually given.

In an embodiment of the present invention, the induction cooktop (1) furthermore comprises
- more than one cooking zone (2) providing the heating of the cooking vessel placed thereon,
- more than one electrical connection part (4) enabling the coils (3) forming the respective cooking zones (2) to be installed detachably and
- more than one generator (5), each providing the driving of a coil (3) through the respective electrical connection part (4) (Figure 1).

Thus, an induction cooktop (1) is realized having more than one cooking zone (2) suitable for heating cooking vessels with different diameters. Each coil (3) forming a cooking zone (2) is driven by a separate generator (5). In an embodiment of the present invention, a single generator (5) is used, comprising current control components (19) that enable the coils (3) to be supplied by the currents suitable for the intended electrical power (Figure 2).

In an embodiment of the present invention, the induction cooktop (1) furthermore comprises an internal recording medium wherein the characteristic information of one or more than one coil (3) to be installed and the configuration data defining the electrical connection parts (4) intended for the said one or more than one coil (3) are recorded. Thus, while the induction cooktop (1) is in the service mode during the production of the induction cooktop (1), it can be determined without requiring manual control whether or not the coils (3) are installed correctly according to the data defined in the internal recording medium. In an embodiment of the present invention, the characteristic information and the configuration data is retrieved by the control unit (6) from an external recording medium with wired or wireless communication.

The coil (3) used in the present invention is suitable to be installed to the electrical connection part (4) of the induction cooktop (1), and in an embodiment of the present invention, the coil (3) comprises a permanent recording medium wherein the characteristic information of the coil (3) and the configuration data defining the electrical connection part (4) intended for the coil (3) to be installed can be recorded and which can be read by the control unit (6) of the induction cooktop (1) by wired or wireless communication. Thus, while the induction cooktop (1) is in the service mode during the production of the induction cooktop (1), it can be determined without requiring manual control whether or not the coils (3) are installed correctly by using the data recorded on, for example, the RFID transponder disposed on the coil (3).

The control method is executed by the control unit (6) of the induction cooktop (1) in the service mode during the production of the induction cooktop, comprising the steps of:
- retrieving the characteristic information defining the characteristic of the coil (3) to be installed and the configuration data of the electrical connection part (4) intended for the coil (3) to be installed from an internal and/or external recording medium,
- driving the coil (3) to be analyzed with a drive signal (7) by operating the generator (5) for a predetermined time period,
- detecting the electric current (8) passing through the coil (3) being analyzed and
- determining whether or not the analyzed coil (3) is correctly installed to the intended electrical connection part (4) depending on the detected coil current (8), the retrieved characteristic information and the retrieved configuration data (Figure 1 to Figure 4).

In an embodiment of the present invention, the control method executed by the control unit (6) of the induction cooktop (1) in the service mode during the production of the induction cooktop, comprises the steps of:
- retrieving the characteristic information of the coil (3) to be installed defining the attenuation duration (9) and the configuration data defining the electrical connection part (4) intended for the coil (3) to be installed from an internal and/or external recording medium in the step of retrieving data,
- driving the coil (3) to be analyzed with a drive signal (7) by instantaneously operating the generator (5) in the step of operating the generator (5),
- detecting the attenuation duration (9) of the electric current (8) passing through the coil (3) being analyzed in the step of detecting the coil current (8), and
- determining whether or not the analyzed coil (3) is correctly installed to the intended electrical connection part (4) depending on the detected attenuation duration (9), the retrieved characteristic information and the retrieved configuration data of the coil (3) to be installed in the step of determining (Figure 3).

In an embodiment of the present invention, the control method executed by the control unit (6) of the induction cooktop (1) in the service mode during the production of the induction cooktop, comprises the steps of:
- retrieving the characteristic information defining the phase difference (10) between the current (8) and the drive signal (7) of the coil (3) to be installed and the configuration data defining the electrical connection part (4) intended for the coil (3) to be installed from an internal and/or external recording medium in the step of retrieving data,
- driving the coil (3) to be analyzed with a drive signal (7) by operating the generator (5) for a predetermined time period in the step of operating the generator (5),
- detecting the phase difference (10) between the electric current (8) passing through the coil (3) being analyzed and the drive signal (7) driving the coil (3) being analyzed in the step of detecting the coil current (8), and
- determining whether or not the analyzed coil (3) is correctly installed to the intended electrical connection part (4) depending on the detected attenuation duration (10), the retrieved characteristic information and the retrieved configuration data of the coil (3) to be installed in the step of determining (Figure 4).

In the step of operating the generator (5), the coil (3) forming the cooking zone (2) is preferred to be driven while load is present thereon. For this purpose, a component composed of a ferromagnetic material is used as the load which is suitable to the diameter and electrical power of the coil (3) being analyzed and that can serve the function of the cooking vessel to be heated. For convenience, a ferromagnetic component is used, having a predetermined diameter and which can be heated by the coil (3) forming each cooking zone (2) of the induction cooktop (1). The phase differences (10) to be detected in the situation wherein this ferromagnetic component is used are predetermined and used as the characteristic information in the service mode.

Furthermore, in the control method executed by the control unit (6) of the induction cooktop (1) in the service mode, the step of retrieving information, the step of operating the generator (5), the step of detecting the coil current (8) and the step of determining are realized respectively for each coil (3) to be installed. Thus, all the coils (3) to be installed to the induction cooktop (1) are enabled to be installed without any errors (Figure 1).

The control method executed by the control unit (6) of the induction cooktop (1) in the service mode during the production of the induction cooktop, furthermore comprises the step of:
- enabling the analysis result, defining whether or not the analyzed coil (3) is installed correctly to the intended electrical connection part (4), to be shown on a display depending on the result of determination (Figure 1).

Thus, the warning that an analyzed coil (3) is installed incorrectly and/or being defective can be visually given.

The control program executed by the control unit (6) enables the induction cooktop (1) to realize all the steps of a method as in any one of the above control methods.

The recording medium is a recording medium that is suitable to be read by a microprocessor and the control program of the present invention is recorded thereon. Preferably, the characteristic information defining the characteristics of the coils (3) to be installed to the induction cooktop (1) of the present invention and the configuration data defining the intended electrical connection parts (4) of the coils (3) to be installed can be recorded to this recording medium.

By means of the present invention, an induction cooktop (1) is realized, that enables the determination of whether or not the coils (3) are installed correctly during the production of the induction cooktop (1) without requiring manual control and with the electronic software and hardware while the induction cooktop (1) is energized in the service mode.

## Claims

1. An induction cooktop (1) comprising
- at least one cooking zone (2) providing the heating of a cooking vessel placed thereon,
- an electrical connection part (4) that enables the coil (3) forming the cooking zone (2) to be installed detachably,
- a generator (5) providing the driving of the coil (3) through the respective electrical connection part (4),
- a control unit (6):
- that enables the generator (5) to be controlled,
- that has a normal operating mode wherein the cooking vessel is heated and a service mode, configured to be executed during the production of the induction cooktop (1),
wherein it is determined whether or not a coil (3) is correctly installed to the electrical connection part (4) whereto it is intended to be installed,
- that, in the service mode, retrieves the characteristic information defining the characteristic of the coil (3) to be installed and the configuration data of the electrical connection part (4) intended for the coil (3) to be installed from an internal and/or external recording medium,
- that provides the driving of the coil (3) to be analyzed with a drive signal (7) by operating the generator (5) for a predetermined time period,
- that detects the electric current (8) passing through the coil (3) being analyzed and
- that determines whether or not the analyzed coil (3) is correctly installed to the intended electrical connection part (4) depending on the detected coil current (8), the retrieved characteristic information and the retrieved configuration data.

2. An induction cooktop (1) as in Claim 1, **characterized by** the control unit (6) wherein the characteristic information defining the attenuation duration (9) of each coil (3) and/or the phase difference (10) between the current (8) of each coil (3) and the voltage generated by the drive signal (7) applied on the coil (3) is recorded.

3. An induction cooktop (1) as in Claim 1 or 2, **characterized by** the control unit (6)
- that retrieves the characteristic information of the coil (3) to be installed defining the attenuation duration (9) of the coil (3) to be installed and the configuration data of the electrical connection part (4) intended for the coil (3) to be installed from an internal and/or external recording medium in the service mode,
- that provides the driving of the coil (3) to be analyzed with a drive signal (7) by instantaneously operating the generator (5),
- that detects the attenuation duration (9) of the electric current (8) passing through the coil (3) being analyzed and
- that determines whether or not the analyzed coil (3) is correctly installed to the intended electrical connection part (4) depending on the detected attenuation duration (9), the retrieved characteristic information and the retrieved configuration data for the coil (3) to be installed.

4. An induction cooktop (1) as in Claim 1 or 2, **characterized by** the control unit (6)
- that retrieves the characteristic information defining the phase difference (10) between the current (8) of the coil (3) to be installed and the drive signal (7) and the configuration data defining the electrical connection part (4) intended for the coil (3) to be installed from an internal and/or external recording medium in the service mode,
- that drives the coil (3) to be analyzed with a drive signal (7) by operating the generator (5) for a predetermined time period,
- that detects the phase difference (10) between the electric current (8) passing through the coil (3) being analyzed and the drive signal (7) driving the coil (3) being analyzed and
- that determines whether or not the analyzed coil (3) is correctly installed to the intended electrical connection part (4) depending on the detected phase difference (10), the retrieved characteristic information and the retrieved configuration data of the coil (3) to be installed.

5. An induction cooktop (1) as in any one of the claims 1 to 4, **characterized by**
- a control panel (11)
- that has a display that enables the analysis result, defining whether or not the analyzed coil (3) is installed correctly to the intended electrical connection part (4) to be shown,
- that is connected to the control unit (6) bi-directionally and
- that has a user input area enabling the user to enter input in order to activate or deactivate the cooking zones (2), and
- the control unit (6) that enables the analysis result, defining whether or not the analyzed coil (3) is installed correctly to the intended electrical connection part (4) to be shown in the display in the service mode depending on the result of determination.

6. An induction cooktop (1) as in any one of the claims 1 to 5, **characterized by**
- more than one cooking zone (2), each providing the heating of a cooking vessel placed thereon,
- more than one electrical connection part (4), each enabling a coil (3) forming the respective cooking zone (2) to be installed detachably,
- more than one generator (5), each providing the driving of the coils (3) through the respective electrical connection parts (4).

7. An induction cooktop (1) as in any one of the claims 1 to 6, **characterized by** the internal recording medium wherein the characteristic information of one or more than one coil (3) to be installed and the configuration data defining the electrical connection parts (4) intended for the said one or more than one coil (3) are recorded.

8. A coil (3) suitable to be installed to the electrical connection part (4) of the induction cooktop (1) as in any one of the claims 1 to 7, **characterized by** a permanent recording medium wherein the characteristic information of the coil (3) and
the configuration data defining the electrical connection part (4) intended for the installation of the coil (3) are recorded and which can be read by the control unit (6) of the induction cooktop (1) by wired or wireless communication.

9. A control method configured to be executed in the service mode during the production of an induction cooktop by the control unit (6) of the induction cooktop (1) as in any one of the claims 1 to 8, comprising the steps of:
- retrieving the characteristic information defining the characteristic of the coil (3) to be installed and the configuration data of the electrical connection part (4) intended for the coil (3) to be installed from an internal and/or external recording medium,
- driving the coil (3) to be analyzed with a drive signal (7) by operating the generator (5) for a predetermined time period,
- detecting the electric current (8) passing through the coil (3) being analyzed and
- determining whether or not the analyzed coil (3) is correctly installed to the intended electrical connection part (4) depending on the detected coil current (8), the retrieved characteristic information and the retrieved configuration data.

10. A control method as in Claim 9, executed by the control unit (6) in the service mode, comprising the steps of:
- retrieving the characteristic information of the coil (3) to be installed defining the attenuation duration (9) and the configuration data of the electrical connection part (4) intended for the coil (3) to be installed from an internal and/or external recording medium in the step of retrieving data,
- driving the coil (3) to be analyzed with a drive signal (7) by instantaneously operating the generator (5) in the step of operating the generator (5),
- detecting the attenuation duration (9) of the electric current (8) passing through the coil (3) being analyzed in the step of detecting the coil current (8), and
- determining whether or not the analyzed coil (3) is correctly installed to the intended electrical connection part (4) depending on the detected attenuation duration (9), the retrieved characteristic information and the retrieved configuration data of the coil (3) to be installed.

11. A control method as in Claim 9, executed by the control unit (6) in the service mode, comprising the steps of:
- retrieving the characteristic information defining the phase difference (10) between the current (8) of the coil (3) to be installed and the drive signal (7) and the configuration data defining the electrical connection part (4) intended for the coil (3) to be installed from an internal and/or external recording medium in the step of retrieving data,
- driving the coil (3) to be analyzed with a drive signal (7) by operating the generator (5) for a predetermined time period in the step of operating the generator (5),
- detecting the phase difference (10) between the electric current (8) passing through the coil (3) being analyzed and the drive signal (7) driving the coil (3) being analyzed in the step of detecting the coil current (8), and
- determining whether or not the analyzed coil (3) is correctly installed to the intended electrical connection part (4) depending on the detected phase difference (10), the retrieved characteristic information and the retrieved configuration data of the coil (3) to be installed.

12. A control method as in claims 9 to 11, executed by the control unit (6) in the service mode,
- wherein the step of retrieving data, the step of operating the generator (5), the step of detecting the current (8) and the step of the determining are realized for each coil (3) to be installed respectively.

13. A control method as in claims 9 to 12, executed by the control unit (6) in the service mode,
- comprising the step of showing on a display the analysis result defining whether or not the analyzed coil (3) is installed correctly to the intended electrical connection part (4) depending on the result of determination.

## Patentansprüche

1. Induktionskochfeld (1), umfassend
- mindestens eine Kochzone (2), die das Erwärmen eines darauf platzierten Kochgefäßes vorsieht,
- ein elektrische Verbindungsteil (4), das es ermöglicht, dass die die Kochzone (2) bildende Spule (3) lösbar installiert werden kann,
- einen Generator (5), der den Antrieb der Spule (3) durch die jeweilige elektrische Verbindungsteil (4) vorsieht,
- eine Steuereinheit (6):
- die es ermöglicht, den Generator (5) zu steuern,
- die eine normale Betriebsart hat, wobei das Kochgefäß erwärmt wird und ein Servicemodus, der konfiguriert ist, um während der Herstellung der Induktionskochfeld (1) ausgeführt zu warden, wobei bestimmt wird, ob eine Spule (3) korrekt an die elektrische Verbindungsteil (4) installiert ist oder nicht, wozu sie bestimmt ist,
- dass im Servicemodus die Merkmalsinformationen, die die Charakteristik der zu installierenden Spule (3) definieren, und die Konfigurationsdaten der elektrischen Verbindungsteils (4), das für die zu installierende Spule (3) von einem internen und/oder externen Speichermedium bestimmt ist, abgerufen werden.,
- die den Antrieb der zu analysierenden Spule (3) mit einem Antriebssignal (7) vorsieht, indem sie den Generator (5) für eine vorbestimmte Zeitspanne betreibt,
- der den elektrischen Strom (8) erfasst, der durch die zu analysierende Spule (3) hindurchgeht,
und
- die bestimmt, ob die analysierte Spule (3) in Abhängigkeit vom erfassten Strom (8) der Spule den abgerufenen charakteristischen Informationen und den abgerufenen Konfigurationsdaten korrekt an dem dafür vorgesehene elektrische Verbindungsteil (4) installiert ist oder nicht.

2. Induktionskochfeld (1) nach Anspruch 1, **gekennzeichnet durch dass** die Steuereinheit (6), wobei die charakteristische Information, die die Dämpfungsdauer (9) jeder Spule (3) und/oder die Phasendifferenz (10) zwischen dem Strom (8) jeder Spule (3) und der durch das an die Spule (3) angelegte Antriebssignal (7) erzeugten Spannung definiert, aufgezeichnet ist.

3. Induktionskochfeld (1) nach Anspruch 1 oder 2, **gekennzeichnet durch dass** die Steuereinheit (6)
- die die charakteristischen Informationen der zu installierenden Spule (3), die die Dämpfungsdauer (9) der zu installierenden Spule (3) definieren, und die Konfigurationsdaten des elektrischen Verbindungsteils (4), das für die zu installierende Spule (3) von einem internen und/oder externen Aufzeichnungsmedium im Servicemodus bestimmt ist, abruft,
- die das Antreiben der zu analysierenden Spule (3) mit einem Antriebssignal (7) durch sofortiges Betreiben des Generators (5) vorsieht,
- die die Dämpfungsdauer (9) des durch die zu analysierende Spule (3) fließenden elektrischen Stroms (8) erfasst und
- die bestimmt, ob die analysierte Spule (3) in Abhängigkeit von der erfassten Dämpfungsdauer (9), den abgerufenen charakteristischen Informationen und den abgerufenen Konfigurationsdaten für die zu installierende Spule (3) korrekt an der vorgesehene elektrische Verbindungsteil (4) installiert ist oder nicht.

4. Induktionskochfeld (1) nach Anspruch 1 oder 2, **gekennzeichnet durch dass** die Steuereinheit (6)
- die die charakteristischen Informationen abruft, die die Phasendifferenz (10) zwischen dem Strom (8) der zu installierenden Spule (3) und dem Antriebssignal (7) definieren, und die Konfigurationsdaten, die die elektrische Verbindungsteil (4) definieren, das für die zu installierende Spule (3) von einem internen und/oder externen Speichermedium im Servicemodus bestimmt ist,
- die die zu analysierende Spule (3) mit einem Antriebssignal (7) antreibt, indem sie den Generator (5) für eine vorbestimmte Zeitspanne betreibt,
- die die Phasendifferenz (10) zwischen dem elektrischen Strom (8), der durch die zu analysierende Spule (3) fließt, und dem Antriebssignal (7), das die zu analysierende Spule (3) antreibt, erfasst und
- die bestimmt, ob die analysierte Spule (3) in Abhängigkeit von der erfassten Phasendifferenz (10), den abgerufenen charakteristischen Informationen und den abgerufenen Konfigurationsdaten der zu installierenden Spule (3) korrekt an die vorgesehene elektrische Verbindungsteil (4) installiert ist oder nicht

5. Induktionskochfeld (1) nach einem der Ansprüche 1 bis 4, **gekennzeichnet durch dass**
- ein Steuerfeld (11)
- die eine Anzeige aufweist, die das Analyseergebnis ermöglicht, die definiert, ob die analysierte Spule (3) korrekt an die vorgesehene elektrische Verbindungsteil (4) installiert ist oder nicht, das angezeigt werden soll,
- die bidirektional mit der Steuereinheit (6) verbunden ist und
- die einen Benutzereingabebereich aufweist, der es dem Benutzer ermöglicht, Eingaben zu tätigen, um die Kochzonen (2) zu aktivieren oder zu deaktivieren, und
- die Steuereinheit (6), die das Analyseergebnis ermöglicht, definiert, ob die analysierte Spule (3) korrekt an dem vorgesehenen elektrischen Verbindungsteil (4) installiert ist oder nicht, das in Abhängigkeit vom Ergebnis der Bestimmung in der Anzeige im Servicemodus angezeigt werden soll.

6. Induktionskochfeld (1) nach einem der Ansprüche 1 bis 5, **gekennzeichnet durch dass**
- mehr als eine Kochzone (2), die jeweils die Erwärmung eines darauf platzierten Kochgefäßes vorsieht.,
- mehr als ein elektrische Verbindungsteil (4), von dem jeweils eine die jeweilige Kochzone (2) bildende Spule (3) abnehmbar installiert werden kann,
- mehr als einen Generator (5), der jeweils das Antreiben der Spulen (3) durch die jeweilige elektrische Verbindungsteile (4) vorsieht.

7. Induktionskochfeld (1) nach einem der Ansprüche 1 bis 6, **gekennzeichnet durch dass** das interne Speichermedium, wobei die charakteristischen Informationen einer oder mehrerer zu installierender Spulen (3) und die Konfigurationsdaten, die die für die eine oder mehrere Spulen (3) vorgesehene elektrische Verbindungsteile (4) definieren, aufgezeichnet werden.

8. Spule (3), die geeignet ist, an die elektrische Verbindungsteil (4) der Induktionskochfeld (1) nach einem der Ansprüche 1 bis 7 installiert zu werden, **gekennzeichnet durch dass** ein dauerhaftes Speichermedium, in dem die charakteristischen Informationen der Spule (3) und
die Konfigurationsdaten, die das für die Installation der Spule (3) vorgesehene elektrische Verbindungsteil (4) definieren,
aufgezeichnet sind und die von der Steuereinheit (6) der Induktionskochfeld (1) durch drahtgebundene oder drahtlose Kommunikation gelesen werden können.

9. Steuerverfahren, das konfiguriert ist, um im Servicemodus während der Herstellung einer Induktionskochfeld durch die Steuereinheit (6) der Induktionskochfeld (1) nach einem der Ansprüche 1 bis 8 ausgeführt zu werden, umfassend die Schritte von:
- Abrufen der charakteristischen Informationen, die die Charakteristik der zu installierenden Spule (3) definieren, und der Konfigurationsdaten des elektrischen Verbindungsteils (4), das für die zu installierende Spule (3) bestimmt ist, von einem internen und/oder externen Speichermedium,
- Antreiben der zu analysierenden Spule (3) mit einem Antriebssignal (7) durch Betreiben des Generators (5) für eine vorbestimmte Zeitspanne,
- Erfassen des elektrischen Stroms (8), der durch die zu analysierende Spule (3) hindurchgeht, und
- Bestimmen, ob die analysierte Spule (3) in Abhängigkeit vom erfassten Spulenstrom (8), den abgerufenen charakteristischen Informationen und den abgerufenen Konfigurationsdaten korrekt an dem vorgesehenen elektrischen Verbindungsteil (4) installiert ist oder nicht.

10. Steuerverfahren nach Anspruch 9, das von der Steuereinheit (6) im Servicemodus ausgeführt wird, umfassend die Schritte von:
- Abrufen der charakteristischen Informationen der einzubauenden Spule (3), die die Dämpfungsdauer (9) definieren, und der Konfigurationsdaten des elektrischen Verbindungsteils (4), das für die einzubauende Spule (3) von einem internen und/oder externen Speichermedium bestimmt ist, im Schritt des Abrufs von Daten,
- Antreiben der zu analysierenden Spule (3) mit einem Antriebssignal (7) durch sofortiges Betreiben des Generators (5) in dem Schritt des Betreibens des Generators (5),
- Erfassen der Dämpfungsdauer (9) des elektrischen Stroms (8), der durch die zu analysierende Spule (3) hindurchgeht, in dem Schritt zum Erfassen des Spulenstroms (8), und
- Bestimmen, ob die analysierte Spule (3) in Abhängigkeit von der erfassten Dämpfungsdauer (9), den abgerufenen charakteristischen Informationen und den abgerufenen Konfigurationsdaten der zu installierenden Spule (3) korrekt an dem vorgesehenen elektrischen Verbindungsteil (4) installiert ist oder nicht.

11. Steuerverfahren nach Anspruch 9, das von der Steuereinheit (6) im Servicemodus ausgeführt wird, umfassend die Schritte von:
- Abrufen der charakteristischen Informationen, die die Phasendifferenz (10) zwischen dem Strom (8) der zu installierenden Spule (3) und dem Antriebssignal (7) definieren, und
der Konfigurationsdaten, die den elektrischen Verbindungsteil (4) definieren, der für die zu installierende Spule (3) von einem internen und/oder externen Speichermedium bestimmt ist, in dem Schritt des Abrufens von Daten,
- Antreiben der zu analysierenden Spule (3) mit einem Antriebssignal (7) durch Betreiben des Generators (5) für eine vorbestimmte Zeitspanne in dem Schritt des Betreibens des Generators (5),
- Erfassen der Phasendifferenz (10) zwischen dem elektrischen Strom (8), der durch die zu analysierende Spule (3) hindurchgeht, und dem Antriebssignal (7), das die zu analysierende Spule (3) antreibt, in dem Schritt zum Erfassen des Spulenstroms (8), und
- Bestimmen, ob die analysierte Spule (3) in Abhängigkeit von der erfassten Phasendifferenz (10), den abgerufenen charakteristischen Informationen und den abgerufenen Konfigurationsdaten der zu installierenden Spule (3) korrekt an dem vorgesehenen elektrischen Verbindungsteil (4) installiert ist oder nicht.

12. Steuerverfahren nach den Ansprüchen 9 bis 11, das von der Steuereinheit (6) im Servicemodus ausgeführt wird,
- wobei der Schritt zum Abrufen von Daten, der Schritt zum Betreiben des Generators (5), der Schritt zum Erfassen des Stroms (8) und der Schritt zum Bestimmen für jede zu installierende Spule (3) realisiert sind.

13. Steuerverfahren nach den Ansprüchen 9 bis 12, das von der Steuereinheit (6) im Servicemodus ausgeführt wird,
umfassend den Schritt, auf einer Anzeige das Analyseergebnis anzuzeigen, das definiert, ob die analysierte Spule (3) korrekt an dem vorgesehenen elektrischen Verbindungsteil (4) installiert ist oder nicht, abhängig vom Ergebnis der Bestimmung.

## Revendications

1. Plaque de cuisson à induction (1) comprenant
- au moins une zone de cuisson (2) assurant le chauffage d'un récipient de cuisson placé sur celle-ci,
- une partie de connexion électrique (4) qui permet d'installer de manière amovible la bobine (3) formant la zone de cuisson (2),
- un générateur (5) assurant l'entraînement de la bobine (3) à travers la partie de connexion électrique respective (4),
- une unité de commande (6) :
- qui permet de commander le générateur (5),
- qui présente un mode de fonctionnement normal dans lequel le récipient de cuisson est chauffé et un mode de service, configuré pour être exécuté pendant la production de la plaque de cuisson à induction (1), dans lequel on détermine si une bobine (3) est correctement installée ou non sur la partie de connexion électrique (4) à laquelle elle est destinée à être installée,
- qui, en mode service, récupère les informations caractéristiques définissant la caractéristique de la bobine (3) à installer et les données de configuration de la partie de connexion électrique (4) destinée à la bobine (3) à installer depuis un support d'enregistrement interne et/ou externe,
- qui fournit l'entraînement de la bobine (3) à analyser avec un signal d'entraînement (7) en faisant fonctionner le générateur (5) pendant une période de temps prédéterminée,
- qui détecte le courant électrique (8) passant à travers la bobine (3) à analyser et
- qui détermine si la bobine analysée (3) est correctement installée ou non sur la partie de connexion électrique (4) prévue en fonction du courant de bobine détecté (8), des informations caractéristiques obtenues et des données de configuration obtenues.

2. Plaque de cuisson à induction (1) selon la revendication 1, **caractérisée par** l'unité de commande (6), dans laquelle l'information caractéristique définissant la durée d'atténuation (9) de chaque bobine (3) et/ou la différence de phase (10) entre le courant (8) de chaque bobine (3) et la tension produite par le signal d'entraînement (7) appliqué sur la bobine (3) est enregistrée.

3. Plaque de cuisson à induction (1) selon la revendication 1 ou 2, **caractérisée par** l'unité de commande (6)
- qui récupère les informations caractéristiques de la bobine (3) à installer définissant la durée d'atténuation (9) de la bobine (3) à installer et les données de configuration de la partie de connexion électrique (4) destinée à la bobine (3) à installer depuis un support d'enregistrement interne et/ou externe en mode service,
- qui fournit l'entraînement de la bobine (3) à analyser avec un signal d'entraînement (7) en faisant fonctionner instantanément le générateur (5),
- qui détecte la durée d'atténuation (9) du courant électrique (8) traversant la bobine (3) à analyser et
- qui détermine si la bobine analysée (3) est correctement installée ou non sur la partie de connexion électrique (4) prévue en fonction de la durée d'atténuation détectée (9), des informations caractéristiques extraites et des données de configuration extraites pour la bobine (3) à installer.

4. Plaque de cuisson à induction (1) selon la revendication 1 ou 2, **caractérisée par** l'unité de commande (6)
- qui récupère les informations caractéristiques définissant la différence de phase (10) entre le courant (8) de la bobine (3) à installer et le signal d'entraînement (7) et les données de configuration définissant la partie de connexion électrique (4) destinée à la bobine (3) à installer depuis un support d'enregistrement interne et/ou externe en mode service,
- qui entraîne la bobine (3) à analyser avec un signal d'entraînement (7) en faisant fonctionner le générateur (5) pendant une période de temps prédéterminée,
- qui détecte la différence de phase (10) entre le courant électrique (8) traversant la bobine (3) analysée et le signal d'entraînement (7) entraînant la bobine (3) analysée et
- qui détermine si la bobine analysée (3) est correctement installée ou non sur la partie de connexion électrique (4) prévue en fonction de la différence de phase détectée (10), des informations caractéristiques extraites et des données de configuration extraites de la bobine (3) à installer.

5. Plaque de cuisson à induction (1) selon l'une quelconque des revendications 1 à 4, **caractérisée par**
- un panneau de commande (11)
- qui comporte un afficheur permettant d'afficher le résultat de l'analyse et de déterminer si la bobine analysée (3) est installée correctement ou non sur la partie de connexion électrique (4) prévue à afficher,
- qui est relié à l'unité de commande (6) de manière bidirectionnelle et
- qui comporte une zone de saisie utilisateur permettant à l'utilisateur d'entrer des données afin d'activer ou de désactiver les zones de cuisson (2), et
- l'unité de commande (6) qui permet d'afficher le résultat de l'analyse, en fonction du résultat de la détermination, de déterminer si la bobine analysée (3) est installée correctement ou non sur la partie de connexion électrique (4) prévue à afficher à l'écran en mode service.

6. Plaque de cuisson à induction (1) selon l'une quelconque des revendications 1 à 5, **caractérisée par**
- plus d'une zone de cuisson (2), chacune fournissant le chauffage d'un récipient de cuisson placé sur celle-ci,
- plus d'une partie de connexion électrique (4), chacune permettant d'installer de manière amovible une bobine (3) formant la zone de cuisson (2) correspondante,
- plus d'un générateur (5), chacun assurant l'entraînement des bobines (3) à travers les parties de connexion électrique respectives (4).

7. Plaque de cuisson à induction (1) selon l'une quelconque des revendications 1 à 6, **caractérisée par** le support d'enregistrement interne sur lequel sont enregistrées les informations caractéristiques d'une ou plusieurs bobines (3) à installer et les données de configuration définissant les parties de connexion électrique (4) destinées à ladite une ou plusieurs bobines (3).

8. Bobine (3) appropriée pour être installée sur la partie de connexion électrique (4) de la plaque de cuisson à induction (1) comme dans l'une quelconque des revendications 1 à 7, **caractérisée par** un support d'enregistrement permanent sur lequel sont enregistrées les informations caractéristiques de la bobine (3) et les données de configuration définissant la partie de connexion électrique (4) destinée à l'installation de la bobine (3) et qui peuvent être lues par l'unité de commande (6) de la plaque de cuisson à induction (1) par communication filaire ou sans fils.

9. Procédé de commande configuré pour être exécuté en mode service pendant la production d'une plaque de cuisson à induction par l'unité de commande (6) de la plaque de cuisson à induction (1) selon l'une quelconque des revendications 1 à 8, comprenant les étapes consistant à:
- récupérer les informations caractéristiques définissant la caractéristique de la bobine (3) à installer et les données de configuration de la partie de connexion électrique (4) destinée à la bobine (3) à installer depuis un support d'enregistrement interne et/ou externe,
- entraîner la bobine (3) à analyser avec un signal d'entraînement (7) en faisant fonctionner le générateur (5) pendant une période de temps prédéterminée,
- détecter le courant électrique (8) passant à travers la bobine (3) à analyser et
- déterminer si la bobine analysée (3) est correctement installée ou non sur la partie de connexion électrique (4) prévue en fonction du courant de bobine détecté (8), des informations caractéristiques obtenues et des données de configuration obtenues.

10. Procédé de commande selon la revendication 9, exécuté par l'unité de commande (6) en mode service, comprenant les étapes consistant à:
- récupérer les informations caractéristiques de la bobine (3) à installer définissant la durée d'atténuation (9) et les données de configuration de la partie de connexion électrique (4) destinée à la bobine (3) à installer depuis un support d'enregistrement interne et/ou externe dans l'étape de récupération des données,
- entraîner de la bobine (3) à analyser avec un signal d'entraînement (7) en faisant fonctionner instantanément le générateur (5) dans l'étape de fonctionnement du générateur (5),
- détecter la durée d'atténuation (9) du courant électrique (8) traversant la bobine (3) analysée dans l'étape de détection du courant (8) de bobine, et
- déterminer si la bobine analysée (3) est correctement installée ou non sur la partie de connexion électrique (4) prévue en fonction de la durée d'atténuation détectée (9), des informations caractéristiques extraites et des données de configuration extraites de la bobine (3) à installer.

11. Procédé de commande selon la revendication 9, exécuté par l'unité de commande (6) en mode service, comprenant les étapes consistant à:
- récupérer les informations caractéristiques définissant la différence de phase (10) entre le courant (8) de la bobine (3) à installer et le signal d'entraînement (7) et les données de configuration définissant la partie de connexion électrique (4) destinée à la bobine (3) à installer depuis un support d'enregistrement interne et/ou externe dans l'étape de récupération des données,
- entraîner la bobine (3) à analyser avec un signal d'entraînement (7) en faisant fonctionner le générateur (5) pendant une période de temps prédéterminée dans l'étape de fonctionnement du générateur (5),
- détecter la différence de phase (10) entre le courant électrique (8) traversant la bobine (3) analysée et le signal d'entraînement (7) entraînant la bobine (3) analysée dans l'étape de détection du courant (8) de bobine, et
- déterminer si la bobine analysée (3) est correctement installée ou non sur la partie de connexion électrique (4) prévue en fonction de la différence de phase détectée (10), des informations caractéristiques extraites et des données de configuration extraites de la bobine (3) à installer.

12. Procédé de commande selon les revendications 9 à 11, exécuté par l'unité de commande (6) en mode service,
- dans lequel l'étape de récupération de données, l'étape de fonctionnement du générateur (5), l'étape de détection du courant (8) et l'étape de détermination sont réalisées pour chaque bobine (3) à installer respectivement.

13. Procédé de commande selon les revendications 9 à 12, exécuté par l'unité de commande (6) en mode service,
- comprenant l'étape consistant à afficher sur un afficheur le résultat d'analyse définissant si la bobine analysée (3) est installée correctement ou non sur la partie de connexion électrique (4) prévue en fonction du résultat de la détermination.
